# EUROPÄISCHE PATENTSCHRIFT

(11) **EP 1 081 765 B1**
(45) Veröffentlichungstag und Bekanntmachung des Hinweises auf die Patenterteilung: **19.07.2006**
(21) Anmeldenummer: 00109566.0
(22) Anmeldetag: 04.05.2000
(51) Int. Cl.: H01L 27/02

(54) **Gegen Verpolung geschützte integrierbare Schaltungsanordnung in einem Substrat**
Integrated circuit built in a substrate protected against a voltage reversal
Circuit intégré dans un substrat protégé contre une inversion de tension

(30) Priorität: 31.08.1999 DE 19941342
(43) Veröffentlichungstag der Anmeldung: 07.03.2001
(73) Patentinhaber: Infineon Technologies AG, 81669 München (DE)
(72) Erfinder: Schrittesser, Gerold, 9231 Köstenberg (AT); Tihanyi, Jenoe, 85551 Kirchheim (DE); Sander, Rainald, 81543 München (DE)
(74) Vertreter: Bickel, Michael

(56) Entgegenhaltungen:
- EP-A- 0 146 042
- EP-A- 0 240 436
- EP-A- 0 765 025
- EP-A- 0 789 398
- DE-A- 4 423 733
- DE-C- 19 522 516
- US-A- 5 491 358
- TIHANYI J: "PROTECTION OF POWER MOSFETS FROM TRANSIENT OVERVOLTAGES" SIEMENS FORSCHUNGS- UND ENTWICKLUNGSBERICHTE,DE,SPRINGER VERLAG. BERLIN, Bd. 14, Nr. 2, 1985, Seiten 56-61, XP002047361 ISSN: 0370-9736

## Beschreibung

Die folgende Erfindung betrifft eine gegen Verpolung geschützte, integrierbare Schaltungsanordnung in einem Substrat vom ersten Leitfähigkeitstyp mit einer ersten und einer zweiten, der ersten gegenüberliegenden Hauptfläche. Das Substrat weist mindestens eine erste Wanne vom zweiten Leitfähigkeitstyp auf, die zumindest ein durch Feldeffekt steuerbares Halbleiterbauelement beinhaltet. Die erste Wanne reicht dabei an die erste Hauptseite.

Monolithisch integrierte Schaltungsanordnungen werden in einem Halbleitersubstrat realisiert, das n- oder p-leitend sein kann. Ist das Substrat beispielsweise n-leitend, so werden die Halbleiterelemente der integrierten Schaltungsanordnung in einer p-Wanne, welche in dem Substrat angeordnet ist, vorgesehen. Die gesamte Schaltungsanordnung kann dabei entweder in einer einzigen Wanne oder aber in einer Mehrzahl an Wannen in dem Substrat vorgesehen sein.

Häufig werden auch Leistungs-Bauelemente zusammen mit Logik-Bauelementen zusammen in einem Substrat realisiert. Die Logik-Bauelemente sind dabei dann gegen das Leistungs-Bauelement Isoliert. Bei dem angeführten Beispiel mit einem n-leitenden Substrat findet die elektrische Isolierung durch den pn-Übergang, welcher durch die p-Wanne und das Substrat gebildet ist, statt. Das n-leitende Substrat muß dann gegenüber den p-Wannen ein höheres Potential aufweisen. In diesem Fall wird von einer sogenannten selbstisolierenden Technologie gesprochen. Die elektrischen Kontakte der Logik-Bauelemente befinden sich auf der Hauptfläche des Substrats, an die die Wanne, in der die Logik-Bauelemente integriert sind, reicht. Dieser Hauptseite wird im folgenden als erste Hauptfläche bezeichnet. Ist zusätzlich ein Leistungs-Bauelement vorgesehen, so wird dieses häufig in vertikaler Form realisiert, d. h. die zweite Hauptfläche des Substrates ist üblicherweise mit einem hohen Versorgungspotential verbunden.

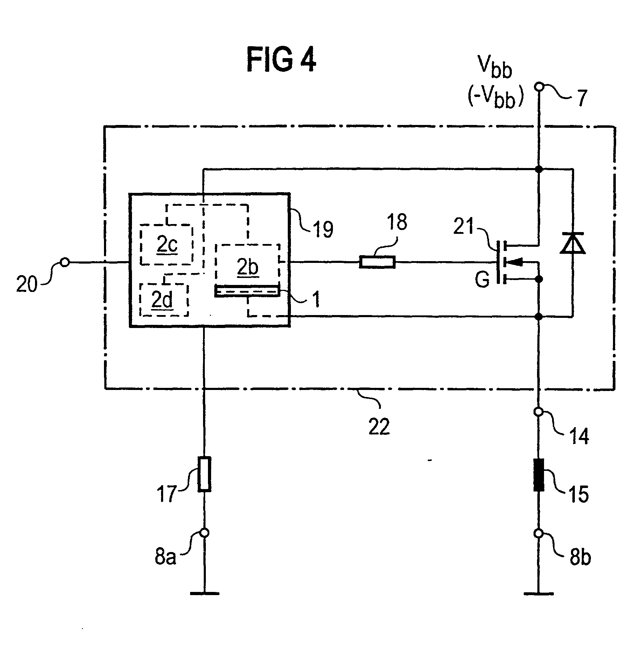

Die obige, beispielhaft beschriebene Anordnung kann einen intelligenten Halbleiterschalter darstellen. Eine solche Anordnung ist zum Beispiel im Dokument DE 44 23 733 A1 beschrieben werden. Die prinzipielle Schaltungsanordnung eines intelligenten Leistungshalberschalters ist in Figur 4 dargestellt. Die Figur zeigt einen sogenannten High-Side-Schalter. Dieser zeichnet sich dadurch aus, daß der Halbleiterschalter 21, der in der vorliegenden Figur als MOSFET dargestellt ist, drainseitig mit einem hohen Versorgungspotential V_{bb} verbunden ist. Dieses liegt an einem Versorgungspotentialanschluß 7 an. Sourceseitig ist dem MOSFET 7 eine Last 15 in Reihe geschaltet, deren nicht mit dem MOSFET 7 verbundene Anschluß an einem Bezugspotentialanschluß 8b liegt, welches üblicherweise das Massepotential darstellt.

Der MOSFET 21 wird von einer Ansteuerschaltung 19 gesteuert, die alle Elemente zur Steuerung des High-Side-Schalters enthält. Dazu gehören z. B. eine Ladungspumpe mit, der die Gatespannung des MOSFETs auf einen Wert eingestellt werden kann, der höher ist als die Versorgungsspannung V_{bb}. Weiter gehört dazu ein Halbleiterschalter, der zwischen dem Gateanschluß und dem Sourceanschluß des MOSFETs 21 geschalten ist und mit dem der MOSFET 21 abgeschaltet werden kann. Außerdem enthält die Ansteuerschaltung 19 wenigstens einen Transistor in der Gatezuleitung, mit dem der Ladestrom für die Gate-Source-Kapazität des MOSFETs 21 gesteuert werden kann. Der Aufbau des Funktionsblocks ist an sich bekannt und daher nicht Gegenstand der Erfindung. Die Ansteuerschaltung 19 ist ferner über einen Widerstand 17 mit einem Bezugspotentialanschluß 8a verbunden. Sie wird über einen Steueranschluß geschalten und ist ferner mit dem Versorgungspotentialanschluß 7 verbunden, wobei dieser sich üblicherweise auf der zweiten Hauptfläche des Substrats befindet.

Die zur Ansteuerung des Halbleiterschalters 21 notwendigen Elemente sind üblicherweise zusammen in einer ersten Wanne 2b integriert, welche in einem Substrat 1 (schematisch angedeutet) vorgesehen ist. Die Wanne 2b ist dabei üblicherweise mit dem Source-Anschluß S des MOSFETs 21 verbunden. In der Ansteuerung 19 können weitere Wannen 2c, 2d vorgesehen sein, die beispielsweise einen Übertemperaturschutz oder eine Überstromerkennung beinhalten. Die Wannen 2b, 2c, 2d sind dabei elektrisch voneinander getrennt.

Die Bezugspotentialanschlüsse 8a, 8b, weisen im Falle der vorliegenden Schaltungsanordnung keine direkte elektrische Verbindung zueinander auf.

Ein für die Schaltungsanordnung kritischer Zustand besteht dann, wenn die am Versorgungspotentialanschluß 7 anliegende Potential unter das am Bezugspotentialanschluß 8a, 8b fällt, d. h. eine Verpolung vorliegt. In diesem Fall kann ein Strom über die im MOSFET 21 technologisch bedingte Reversdiode vom Bezugspotentialanschluß 8b zum Versorgungspotentialanschluß 7 fließen. Es wird eine hohe Verlustleistung in dem MOSFET 21 umgesetzt, welche zu einer Zerstörung des intelligenten Halbleiterschalters führen kann. Der verpolte Zustand ist gleichermaßen für die Ansteuerschaltung 19 kritisch, da die Selbstisolierung nicht mehr wirkt und auch dort eine hohe thermische Verlustleistung umgesetzt wird. Um eine thermische Zerstörung der integrierten Schaltungsanordnung zu verhindern, ist es deshalb in einem Verpolfall notwendig, den MOSFET 21 aufzusteuern, so daß ein Strom durch die technologisch bedingte Reversdiode vermieden wird.

Die Aufgabe der vorliegenden Erfindung besteht deshalb darin, eine Schaltungsanordnung anzugeben, die einen Ausfall der Schaltungsanordnung in einem Verpolfall verhindert. Die Schaltungsanordnung soll ferner technologisch integrierbar sein.

Diese Aufgabe wird mit den Merkmalen des Patentanspruchs 1 gelöst.

Die Erfindung geht von der Erkenntnis aus, daß ein seriell mit einer Last zwischen zwei Versorgungspotentialanschlüssen verschalteter ersten Halbleiterschalter in einem Verpolfall leitend gesteuert werden muß. Hierzu muß die Ansteuerschaltung dem ersten Halbleiterschalter an seinem Steueranschluß eine Spannung zur Verfügung stellen, die ausreichend ist, diesen leitend zu schalten. Ist die Ansteuerschaltung in einer selbstisolierenden Technologie in einem Substrat realisiert, so können in einem Verpolfall parasitäre Elemente, z. B. Bipolartransistoren, welche zwischen dem Substrat vom ersten Leitfähigkeitstyp, einer darin befindlichen ersten Wanne vom zweiten Leitfähigkeitstyp und darin integrierten Bauelementen, die Bereiche vom ersten Leitfähigkeitstyp enthalten, gebildet werden, die der gewünschten Funktionsweise entgegenstehen. Dies bedeutet, die Ansteuerschaltung 19 ist im Verpolfall nicht in der Lage, dem Steueranschluß des ersten Halbleiterschalters eine Spannung zur Verfügung zu stellen, die ausreichend ist, den ersten Halbleiterschalter leitend zu schalten. Neben der Beeinträchtigung können durch parasitäre Elemente im Verpolfall auch andere Funktionen, wie z. B. eine Temperaturüberwachung oder ein Überlastschutz gestört werden.

Die erfindungsgemäße gegen Verpolung geschützte, integrierbare Schaltungsanordnung in einem Substrat vom ersten Leitfähigkeitstyp mit einer ersten und einer zweiten, der ersten gegenüberliegenden Hauptfläche mit mindestens einer ersten Wanne vom zweiten Leitfähigkeitstyp, die zumindest ein durch Feldeffekt steuerbares Halbleiterbauelement aufweist, wobei die erste Wanne an die erste Hauptseite reicht und in dem Substrat angeordnet ist, die einen mit dem Substrat verbundenen Versorgungspotentialanschluß aufweist, sieht deshalb vor, mindestens eine zweite, an die erste Hauptfläche reichende Wanne vom zweiten Leitfähigkeitstyp in dem Substrat anzuordnen, die einen Bereich vom ersten Leitfähigkeitstyp aufweist, wobei der Bereich mit mindestens einer ersten Wanne elektrisch verbunden ist.

Die zweite Wanne vom zweiten Leitfähigkeitstyp mit dem darin angeordneten Bereich vom ersten Leitfähigkeitstyp bildet zusammen mit dem Substrat in einem Verpolfall einen weiteren parasitären bipolaren Transistor, dessen Kollektor die bipolaren Transistoren in der mindestens einen ersten Wanne ansteuert und im Verpolfall deren negative Auswirkungen eliminiert. Auf diese Weise kann die Funktionsfähigkeit der in einer Ansteuerschaltung vorgesehenen Funktionen auch im Verpolfall weiter aufrecht erhalten werden, da die Basis des parasitären Bipolartransistors in der ersten Wanne über den weiteren parasitären Bipolartransistor kurzgeschlossen wird.

Vorteilhafte Ausgestaltungen der Erfindung ergeben sich aus den abhängigen Ansprüchen.

In einer vorteilhaften Ausgestaltung ist die zweite Wanne mit einer Stromquelle verbunden, die im Normalfall keinen Strom und die im Verpolfall einen Strom liefert. Auf diese Weise ist sichergestellt, daß die parasitären Bipolartransistoren in der ersten Wanne nur in einem Verpolfall angesteuert werden. Im Normalbetrieb erfolgt keine Beeinflussung durch die mit der zweiten Wanne gebildete Struktur.

Es ist vorteilhaft, die erste Wanne über einen Widerstand auf ein definiertes Potential zu beziehen. In diesem Fall wird ein "Floaten" der ersten Wanne vermieden. Ein Floaten der ersten Wanne könnte in einem Normalbetrieb die Funktionsfähigkeit der darin befindlichen Bauelemente negativ beeinflussen.

In einem Ausführungsbeispiel weist die erfindungsgemäße integrierbare Schaltungsanordnung mehrere erste Wannen auf, wobei in einer der ersten Wannen Elemente zur Ansteuerung des ersten Halbleiterschalters vorgesehen sind. In diesem Fall ist eine besonders einfache Eliminierung der parasitären Bipolartransistoren in der ersten Wanne möglich, da die erste Wanne direkt mit dem Ausgang der integrierten Schaltungsanordnung verbunden ist. In diesem Fall kann die mit der zweiten Wanne verbundene Stromquelle als Widerstand ausgeführt werden, der ebenfalls mit dem Ausgang der Schaltungsanordnung verbunden ist.

In einem weiteren Ausführungsbeispiel ist in einer weiteren der ersten Wannen eine MOS-Diode vorgesehen. Vorteilhafterweise sind die MOS-Diode und ein Widerstand seriell zwischen dem Steueranschluß des ersten Halbleiterschalters und einem Bezugspotentialanschluß verschalten. Mittels der MOS-Diode und dem seriell verschaltenen Widerstand kann auf einfache Weise ein Verpolschutz für den ersten Halbleiterschalter realisiert werden. In diesem Fall ist unabhängig von einer Ansteuerschaltung ein Aufsteuern des ersten Halbleiterschalters in einem Verpolfall gewährleistet. Um die Funktionsfähigkeit des ersten Halbleiterschalters in einem normalen Betriebszustand zu gewährleisten, ist vorteilhafterweise ein zweiter und ein dritter Halbleiterschalter in der ersten Wanne vorgesehen, in der die MOS-Diode integriert ist. Diese bringen im Normalbetrieb den Verbindungspunkt zwischen-der Diode und dem Widerstand auf das Potential des Ausgangsanschlusses.

Weitere Vorteile und Merkmale der Erfindung werden anhand der nachfolgenden Figuren näher erläutert. Es zeigen:
- Figur 1: einen Querschnitt durch die erfindungsgemäße Schaltungsanordnung in integrierter Form,
- Figur 2: eine alternative Ausführungsform eines Querschnitts durch die erfindungsgemäße Schaltungsanordnung in integrierter Form,
- Figur 3: das elektrische Ersatzschaltbild mit einem erfindungsgemäßen Verpolschutz für einen Halbleiterschalter und
- Figur 4: das prinzipielle elektrische Ersatzschaltbild einer Ansteuerung für einen Halbleiterschalter, welcher aus dem Stand der Technik bekannt ist.

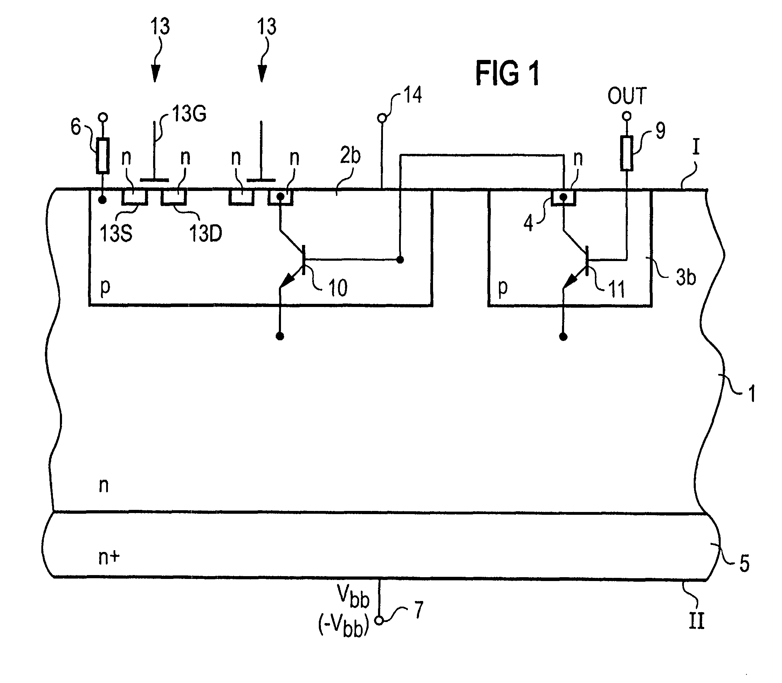

Figur 1 zeigt im Querschnitt einen Ausschnitt aus der erfindungsgemäßen integrierten Schaltungsanordnung. In einem Substrat 1, das im vorliegenden Beispiel n-leitend ist, ist eine erste Wanne 2b angeordnet, die an die erste Hauptfläche I des Substrates 1 reicht. Die erste Wanne 2b ist vom dem Substrat entgegengesetzten Leitfähigkeitstyp, d. h. im vorliegenden Ausführungsbeispiel p-leitend. Stellvertretend für eine komplexe integrierte Schaltungsanordnung in der ersten Wanne 2b sind zwei Halbleiterschalter 13 dargestellt. Die Halbleiterschalter 13 sind als laterale Feldeffekt-gesteuerte Bauelemente dargestellt. Diese weisen einen Steueranschluß 13G, einen n-leitenden Sourcebereich 13S sowie einen ebenfalls n-leitenden Drainbereich 13D auf. In der ersten Wanne 2b sind beispielsweise diejenigen Bauelemente integriert, die zur direkten Ansteuerung eines ersten Halbleiterschalters dienen, der seriell mit einer Last verschalten ist. In diesem Fall ist die erste Wanne 2b mit einem Ausgangsanschluß 14 verbunden, der den Verbindungspunkt zwischen der Last und dem ersten Halbleiterschalter darstellt. Die zweite Hauptfläche II ist mit einem Versorgungspotentialanschluß 7 verbunden, an dem im Normalfall ein hohes Versorgungspotential V_{bb} anliegt.

In einem verpolten Zustand liegt am Versorungspotentialanschluß 7 das niedrigste Versorungspotential, -V_{bb} an. In diesem Fall wird zwischen dem n-leitenden Substrat 1, der p-leitenden ersten Wanne 2b und den Drain- bzw. Sourcebereichen 13D, 13S, der Halbleiterschalter 13 ein parasitärer Bipolartransistor 10 gebildet. Üblicherweise ist die erste Wanne 2b mit einem Widerstand 6 verbunden, der beispielsweise als externer Widerstand ausgeführt sein kann. Der Widerstand 6 dient dazu, die erste Wanne 2b auf einen festen Potential zu halten. Im verpolten Fall würde die Basis des parasitären Bipolartransistors 10 einen über den Widerstand 6 Steuerstrom erhalten, so daß dieser leitend geschalten würde. Die korrekte Funktionsweise der Halbleiterschalter 13 wäre in diesem Fall nicht mehr gewährleistet.

Es ist deshalb in dem Substrat 1 eine zweite Wanne 3b vorgesehen, die p-leitend ist. Die zweite Wanne 3b reicht an die erste Hauptfläche I des Substrates 1. In der zweiten Wanne 3b ist ein Bereich 4 vorgesehen, der n-leitend ist und an die erste Hauptfläche I reicht. Der Bereich 4 ist elektrisch mit der p-leitenden ersten Wanne 2b verbunden. Dies kann beispielsweise über eine Metallisierung erfolgen. Im vorliegenden Beispiel ist diese benachbart der ersten Wanne 2b angeordnet. Dies ist jedoch nicht zwingend notwendig. Relevant ist eine elektrische Verbindung zwischen dem Bereich 4 und der ersten Wanne, so daß die örtliche Anordnung eine untergeordnete Rolle spielt. Die zweite Wanne 3b ist ferner über einen Widerstand 9 angeschlossen. Ist, wie im vorliegenden Fall, die erste Wanne 2b mit dem Ausgangsanschluß 14 verbunden, so ist der Widerstand 9 ebenfalls mit dem Ausgangsanschluß 14 verbunden. Besteht jedoch keine Verbindung der p-leitenden ersten Wanne mit dem Ausgangsanschluß 14, so ist der Widerstand 9 mit einem Bezugspotentialanschluß zu verbinden. Dies wäre beispielsweise bei logischen Funktionen der Fall, die nicht der Ansteuerung des ersten Halbleiterschalters dienen.

Durch das Substrat 1, die zweite Wanne 3b und den Bereich 4 ist ein weiterer parasitärer Bipolartransistor 11 gebildet. In einem Verpolfall ist der Kollektor des parasitären Bipolartransistors 11 mit der Basis des parasitären Bipolartransistors 10 in der ersten Wanne 2b verbunden. Der Ausgangsanschluß 14 ist in diesem Fall (über eine Last) auf einen hohen Potential, d. h. er liefert über den Widerstand 9 dem Bipolartransistor 11 einen Steuerstrom, der seinerseits die Basis des parasitären Bipolartransistors 10 ansteuert. Die funktionsstörende Wirkung des Bipolartransistors 10 in der ersten Wanne 2b kann auf diese Weise verhindert werden.

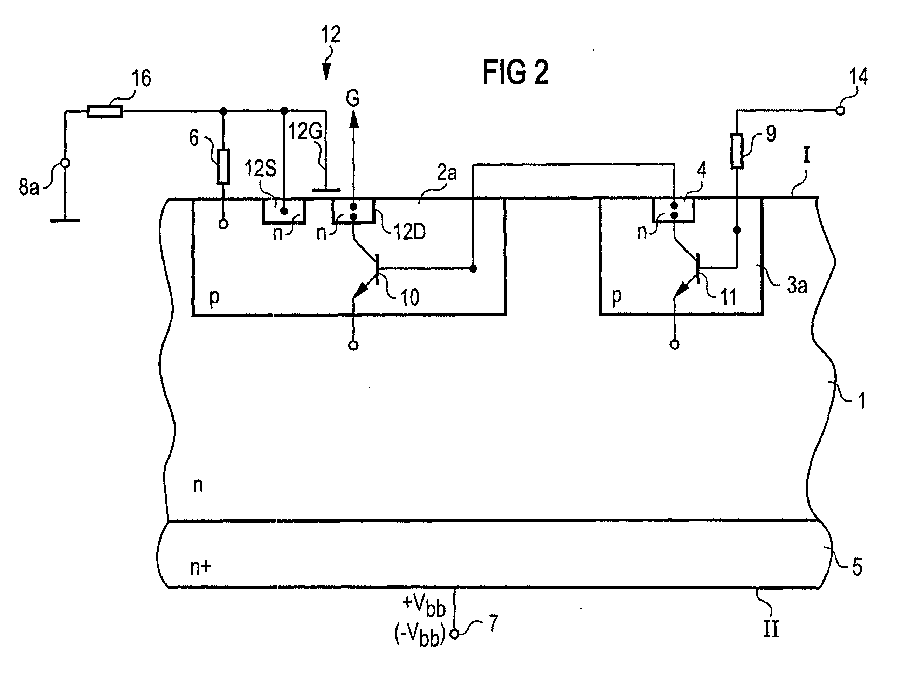

Figur 2 zeigt eine Variation der in Figur 1 beschriebenen integrierten Schaltungsanordnung. In einer ersten Wanne 2a, die nicht identisch mit der ersten Wanne 2b aus Figur 1 ist, ist eine MOS-Diode 12 vorgesehen. Der Source-Anschluß 12S der MOS-Diode 12 ist mit dem Gate-Anschluß 12G verbunden. Dieser ist ferner über einen externen Widerstand 16 mit einem Bezugspotentialanschluß 8a verbunden. Mit dem Drain der MOS-Diode 12 ist über einen Widerstand 18 der Steueranschluß eines ersten Halbleiterschalters 21 verbunden. Benachbart der ersten Wanne 2a ist eine zweite Wanne 3a vorgesehen, die in das Substrat 1 eingebracht ist. An die erste Hauptfläche I reichend ist ferner ein n-leitender Bereich 4 vorgesehen. Der Bereich 4 ist über eine elektrische Verbindung mit der ersten Wanne 2a verbunden. Die zweite Wanne 3a und die zweiten Wanne 3b aus Figur 1 sind nicht identisch. Es besteht auch keine elektrische Verbindung zwischen diesen beiden Bereichen. Der in der Figur 2 dargestellte Ausschnitt der erfindungsgemäßen Schaltungsanordnung ermöglicht in einfacher Weise einen Verpolschutz für einen Halbleiterschalter. Im Fall einer Verpolung steuert der Bipolartransistor 11 den Bipolartransistor 10 in der ersten Wanne 2a auf, so daß an den Steueranschluß des ersten Halbleiterschalters eine ausreichend hohe Spannung angelegt werden kann, um diesen im Falle einer Verpolung leitend zu steuern.

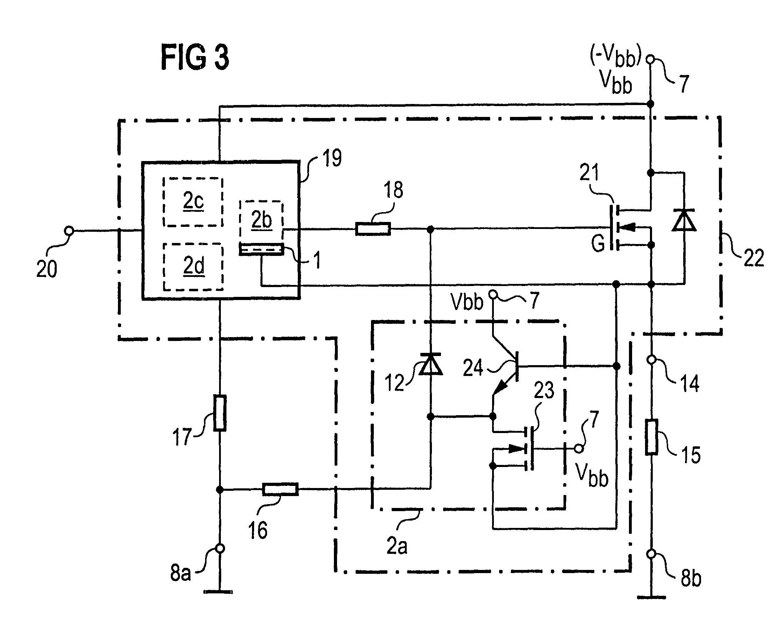

Die Funktionsweise des erfindungsgemäßen Verpolschutzes wird aus Figur 3 ersichtlich. Figur 3 zeigt das prinzipielle elektrische Ersatzschaltbild der erfindungsgemäßen Verpolschutz für den eingangs bereits beschriebenen High-Side-Halbleiterschalter. Zwischen einem Versorgungspotentialanschluß 7 und einem Bezugspotentialanschluß 8b ist die Reihenschaltung aus einem ersten Halbleiterschalter 21 und einer Last 15 verschalten. Der erste Halbleiterschalter 21, der im vorliegenden Beispiel als MOSFET ausgeführt ist, ist drainseitig mit dem Versorungsootentialanschluß 7 verschalten. Der Verbindungsanschluß zwischen dem Source-Anschluß und der Last 15 bildet einen Ausgangsanschluß 14. Der MOSFET 21 wird über eine Ansteuerschaltung 19 gesteuert. Zwischen der Ansteuerschaltung 19 und dem Gate-Anschluß ist ein Gateladewiderstand 18 vorgesehen. Die Ansteuerschaltung 19 wird über einen Steueranschluß 20 gesteuert. Die in der Ansteuerschaltung 19 strichliert dargestellte Bereiche 2b bis 2d sollen in unterschiedliche Funktionsblöcke eines intelligenten Halbleiterschalters andeuten, die jeweils in unterschiedlichen ersten Wannen 2b, 2c oder 2d realisiert sind. Die erste Wanne 2b vereint dabei die zur Ansteuerung des Gate-Anschlusses G notwendigen Bauelemente. Die erste Wanne 2b ist wie in der Figur 1 dargestellt in dem Substrat 1 untergebracht, wobei dieses mit dem Ausgangsanschluß 14 verbunden ist. Die Ansteuerschaltung 19 ist ferner über einen Widerstand 17 mit einem Bezugspotentialanschluß 8a verbunden. Die Bezugspotentialanschlüsse 8a und 8b weisen keine elektrische Verbindung zueinander auf.

Der erfindungsgemäße Verpolschutz der vorliegenden Erfindung besteht aus einer Diode 12 und einem Widerstand 16, die seriell zwischen dem Gate G und dem Bezugspotentialanschluß 8a verschalten sind. Kathodenseitig ist die Diode 12 dabei mit dem Gate G des MOSFETs 21 verbunden. Der erfindungsgemäße Verpolschutz weist ferner einen zweiten und einen dritten Halbleiterschalter 23, 24 auf, deren Laststrecken seriell zwischen dem Versorgungspotentialanschluß 7 und dem Ausgangsanschluß 14 verschalten sind. Der zweite Halbleiterschalter 23 ist dabei als MOSFET realisiert, während der dritte Halbleiterschalter 24 als Bipolartransistor ausgeführt ist. Der Kollektor des Bipolartransistors 24 ist mit dem Versorgungspotentialanschluß 7 verbunden. Der Emiter des Biplartransistors 24 ist einerseits mit dem Drainanschluß des MOSFETs 23 und andererseits mit dem Verbindungspunkt aus dem Widerstand 16 und der Diode 12 verbunden. Der Basisanschluß des Bipolartransistors 24 ist mit dem Source-Anschluß des MOSFETs 23 verbunden. Das Gate des MOSFETs 23 ist mit dem Versorgungspotentialanschluß 7 verbunden.

Wird an dem Versorungspotentialanschluß 7 ein negatives Potential -V_{bb} angelegt, so liegt das Gate des MOSFETs 21 eine Diodenspannung über dem Bezugspotential 8a. Somit ist sichergestellt, daß der MOSFET 21 in einem Verpolfall aufgesteuert wird. Im Normalbetrieb sorgen die Halbleiterschalter 23, 24 dafür, daß der Verbindungspunkt zwischen der Diode 12 und dem Widerstand 16 auf dem Potential des Ausgangsanschlusses 14 liegt. Somit wird die Funktion der Ansteuerschaltung 19 im Normalbetrieb nicht beeinträchtigt. Der MOSFET 23 ist im Normalbetrieb leitend gesteuert, da das Potential an seinem Gate über dem Potential des Source-Anschlusses liegt.

Durch das Beeinflussen der parasitären Bauelemente in der Ansteuerschaltung 19 und in der in integrierter Form als MOS-Diode 12 ausgeführten Diode mittels gezielter Erzeugung einer weiteren parasitären Struktur kann in vorteilhafter Weise ein Verpolfall beherrscht werden.

## Patentansprüche

1. Gegen Verpolung geschützte, integrierbare Schaltungsanordnung in einem Substrat (1) vom ersten Leitfähigkeitstyp mit einer ersten und einer zweiten, der ersten gegenüberliegenden Hauptfläche (I, II) mit:
- mindestens einer ersten Wanne (2a-2d) vom zweiten Leitfähigkeitstyp, die zumindest ein durch Feldeffekt steuerbares Halbleiterbauelement (12, 13, 23, 24) aufweist, und die an die erste Hauptseite (I) reichend in dem Substrat (1) angeordnet ist
- einem mit dem Substrat (1) verbundenen Versorgungspotentialanschluß (7)
- mindestens einer zweiten, an die erste Hauptfläche (I) reichende, Wanne (3a, 3b) vom zweiten Leitfähigkeitstyp in dem Substrat (1), die einen Bereich (4) vom ersten Leitfähigkeitstyp aufweist, wobei der Bereich (4) mit mindestens einer ersten Wanne (2a-2d) unmittelbar elektrisch verbunden ist.

2. Schaltungsanordnung nach Anspruch 1,
**dadurch gekennzeichnet, daß**
die zweite Wanne (3a, 3b) mit einer Stromquelle (9) verbunden ist, die im Normalbetrieb keinen Strom und die im Verpolfall einen Strom liefert.

3. Schaltungsanordnung nach Anspruch 1 oder 2,
**dadurch gekennzeichnet, daß**
die erste Wanne (2a-2d) über einen Widerstand (6) auf ein definiertes Potential gebracht ist.

4. Schaltungsanordnung nach einem der Ansprüche 1 bis 3,
**dadurch gekennzeichnet, daß**
eine der ersten Wannen (2b-2d) Elemente zur Ansteuerung eines ersten Halbleiterschalters (21) beinhaltet, wobei die erste Wanne mit einem Ausgangsanschluß verbunden ist.

5. Schaltungsanordnung nach einem der Ansprüche 1 bis 4,
**dadurch gekennzeichnet, daß**
eine weitere der ersten Wannen (2a) eine MOS-Diode (12) aufweist.

6. Schaltungsanordnung nach Anspruch 5,
**dadurch gekennzeichnet, daß**
die Diode (12) und ein Widerstand (16) seriell zwischen dem Steueranschluß des ersten Halbleiterschalters (21) und einem Bezugspotentialanschluß (8a) verschalten sind.

7. Schaltungsanordnung nach Anspruch 5 oder 6,
**dadurch gekennzeichnet, daß**
ein zweiter und ein dritter Halbleiterschalter (23, 24) in der ersten Wanne (2a) vorgesehen sind, die im Normalbetrieb den Verbindungspunkt zwischen der Diode (12) und dem Widerstand (16) auf das Potential eines ersten Hauptanschlusses des ersten Halbleiterschalter (21) bringen.

8. Schaltungsanordnung nach einem der Ansprüche 4 bis 7,
**dadurch gekennzeichnet, daß**
der erste Hauptanschluß des ersten Halbleiterschalters (21) über den Ausgangsanschluß (14) mit einer Last (15) verbunden wird.

9. Schaltungsanordnung nach einem der Ansprüche 2 bis 8.
**dadurch gekennzeichnet, daß**
die Stromquelle (9) als Widerstand ausgebildet ist, der mit dem ersten Hauptanschluß des ersten Halbleiterschalters (21) verbunden ist.

## Claims

1. Integrable circuit arrangement that is protected against polarity reversal in a substrate (1) of the first conductivity type having a first main area (I) and a second main area (II) that is opposite the first, having:
- at least one first well (2a-2d) of the second conductivity type which has at least one semiconductor component (12, 13, 23, 24) - that can be controlled by means of field effect - and which is arranged in the substrate (1) such that it reaches the first main side (I),
- a supply potential connection (7) that is connected to the substrate (1),
- at least one second well (3a, 3b) of the second conductivity type in the substrate (1), which well reaches the first main area (I) and has a region (4) of the first conductivity type, the region (4) being directly electrically connected to at least one first well (2a-2d).

2. Circuit arrangement according to Claim 1,
**characterized in that**
the second well (3a, 3b) is connected to a current source (9) which, during normal operation, does not provide a current and, in the event of polarity reversal, provides a current.

3. Circuit arrangement according to Claim 1 or 2,
**characterized in that**
the first well (2a-2d) is brought to a defined potential by means of a resistor (6).

4. Circuit arrangement according to one of Claims 1 to 3,
**characterized in that**
one of the first wells (2b-2d) comprises elements for driving a first semiconductor switch (21), the first well being connected to an output connection.

5. Circuit arrangement according to one of Claims 1 to 4,
**characterized in that**
a further one of the first wells (2a) has a MOS diode (12).

6. Circuit arrangement according to Claim 5, **characterized in that**
the diode (12) and a resistor (16) are connected in series between the control connection of the first semiconductor switch (21) and a reference-earth potential connection (8a).

7. Circuit arrangement according to Claim 5 or 6,
**characterized in that**
a second and a third semiconductor switch (23, 24) are provided in the first well (2a), which switches, during normal operation, bring the junction point between the diode (12) and the resistor (16) to the potential of a first main connection of the first semiconductor switch (21).

8. Circuit arrangement according to one of Claims 4 to 7,
**characterized in that**
the first main connection of the first semiconductor switch (21) is connected to a load (15) via the output connection (14).

9. Circuit arrangement according to one of Claims 2 to 8,
**characterized it that**
the current source (9) is in the form of a resistor which is connected to the first main connection of the first semiconductor switch (21).

## Revendications

1. Circuit protégé contre une inversion de tension et intégré dans un substrat (1) d'un premier type de conductibilité avec une première surface principale (I) et une deuxième surface principale (II) opposée à la première, avec:
- au moins une première cuvette (2a-2d) du deuxième type de conductibilité, qui comprend au moins un élément semi-conducteur (12, 13, 23, 24) pouvant être commandé par effet de champ, et qui est disposée sur la première surface principale (I) de façon à pénétrer dans le substrat (1)
- une connexion de potentiel d'alimentation (7) raccordée au substrat (1), et
- au moins une deuxième cuvette (3a, 3b) du deuxième type de conductibilité sur la première surface principale (I) et pénétrant dans le substrat (1), et qui comporte une zone du premier type de conductibilité (4), dans lequel la zone (4) est électriquement raccordée directement à au moins une première cuvette (2a-2d).

2. Circuit selon la revendication 1,
**caractérisé en ce que**
la deuxième cuvette (3a, 3b) est raccordée à une source de courant (9), qui ne fournit aucun courant en fonctionnement normal et qui fournit un courant en cas d'inversion de tension.

3. Circuit selon la revendication 1 ou 2,
**caractérisé en ce que**
la première cuvette (2a-2d) est portée à un potentiel défini au moyen d'une résistance (6).

4. Circuit selon l'une quelconque des revendications 1 à 3,
**caractérisé en ce qu'**
une des premières cuvettes (2b-2d) comprend des éléments pour commander un premier commutateur statique (21), dans lequel la première cuvette est reliée à une connexion de sortie.

5. Circuit selon l'une quelconque des revendications 1 à 4,
**caractérisé en ce qu'**
une autre des premières cuvettes (2a) comprend une diode MOS (12).

6. Circuit selon la revendication 5,
**caractérisé en ce que**
la diode (12) et une résistance (16) sont montées en série entre la connexion de commande du premier commutateur statique (21) et une connexion de potentiel de référence (8a).

7. Circuit selon la revendication 5 ou 6,
**caractérisé en ce qu'**
il est prévu un deuxième et un troisième commutateurs statiques (23, 24) dans la première cuvette (2a) qui, en fonctionnement normal, portent le point de raccordement entre la diode (12) et la résistance (16) au potentiel d'une première connexion principale du premier commutateur statique (21).

8. Circuit selon l'une quelconque des revendications 4 à 7,
**caractérisé en ce que**
la première connexion principale du premier commutateur statique (21) est raccordée à une charge (15) par l'intermédiaire de la connexion de sortie (14).

9. Circuit selon l'une quelconque des revendications 2 à 8,
**caractérisé en ce que**
la source de courant (9) est réalisée sous la forme d'une résistance, qui est raccordée à la première connexion principale du premier commutateur statique (21).
